# EUROPEAN PATENT APPLICATION

(11) **EP 3 319 218 A1**
(43) Date of publication of application: **09.05.2018**
(21) Application number: 15897663.9
(22) Date of filing: 03.07.2015
(51) Int. Cl.: H02M 7/48

(54) **POWER CONVERTER CONTROL DEVICE**

(71) Applicant: Toshiba Mitsubishi-Electric Industrial Systems Corporation, Tokyo 104-0031 (JP)
(72) Inventor: MATSUOKA, Yuji, Tokyo 104-0031 (JP); AMBO, Tatsuaki, Tokyo 104-0031 (JP)
(74) Representative: Winter, Brandl, Fürniss, Hübner, Röss, Kaiser, Polte - Partnerschaft mbB
(86) International application number: PCT/JP2015/069318
(87) International publication number: WO 2017/006400

(57) **Abstract**

A control device 5 of a power converter generates individual current command values Ira to Ird based on a total current command value Ir of inverters 2a to 2d; controls the inverters 2a to 2d respectively based on the generated current command values Ira to Ird; senses at least one current of direct currents Iia to lid or alternating currents Ioa to Iod for each of the inverters 2a to 2d; and suppresses the current command values Ira to Ird for each of the inverters 2a to 2d when the sensed current exceeds a current limit value, the current limit value being preset, the current limit value being lower than a current causing a protection operation to protect the inverters 2a to 2d.

## Description

### [Field]

The invention relates to a control device of a power converter.

### [Background Art]

Generally, a power converter (an inverter) is used in a distributed power source. Also, the sensing of the input current of the inverter for sensing an abnormality of the inverter is known. For example, a solar power generation system is discussed in which the solar power generation system is made from a solar cell, from a solar power conditioner that includes an inverter and a system connection protection device, and from a commercial power source; and an abnormality is sensed and the inverter is stopped when the input current value of the inverter becomes greater than the rated input current value of the inverter (referring to Patent Literature 1).

However, in the case where multiple power converters are controlled, a protective stop may be performed due to an overcurrent for one power converter even when the total of the output power of all of the power converters is less than the rated power. This is because the input currents or the output currents become unbalanced between the power converters.

### [Citation List]

### [Patent Literature]

Patent Literature 1: JP-A 2003-284355 (Kokai)

### [Summary of Invention]

An object of the invention is to provide a control device of a power converter that suppresses unnecessary protective stops of a portion of the power converters due to the input currents or the output currents becoming unbalanced between the power converters.

A control device of a power converter according to an aspect of the invention includes: an individual current command value generator generating multiple individual current command values based on a total current command value, the total current command value being a command value for a total output current of multiple power conversion circuits, the multiple individual current command values being command values respectively for output currents of the multiple power conversion circuits; multiple controllers respectively controlling the multiple power conversion circuits based on the multiple individual current command values generated by the individual current command value generator; multiple current sensors sensing at least one current of an input current or an output current for each of the multiple power conversion circuits; and multiple output current suppressors provided respectively for the multiple power conversion circuits, the output current suppressor suppressing the individual current command value when the current sensed by the current sensor exceeds a current limit value, the current limit value being preset, the current limit value being lower than a current causing a protection operation to protect the power conversion circuit.

### [Brief Description of Drawings]

[Fig. 1]

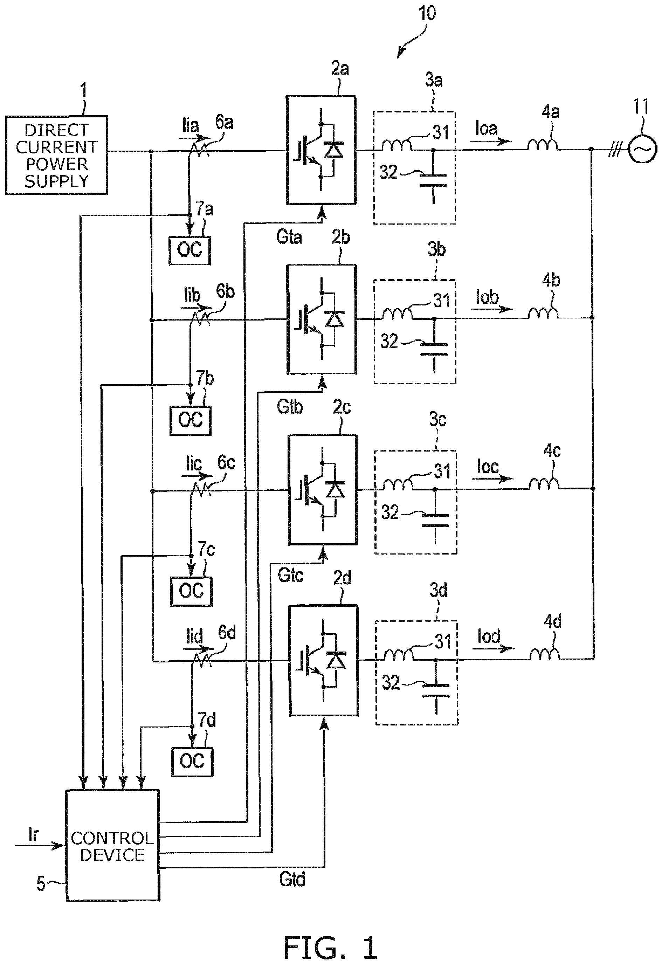

   FIG. 1 is a configuration diagram showing a configuration of a distributed power source system according to a first embodiment of the invention.
[Fig. 2]

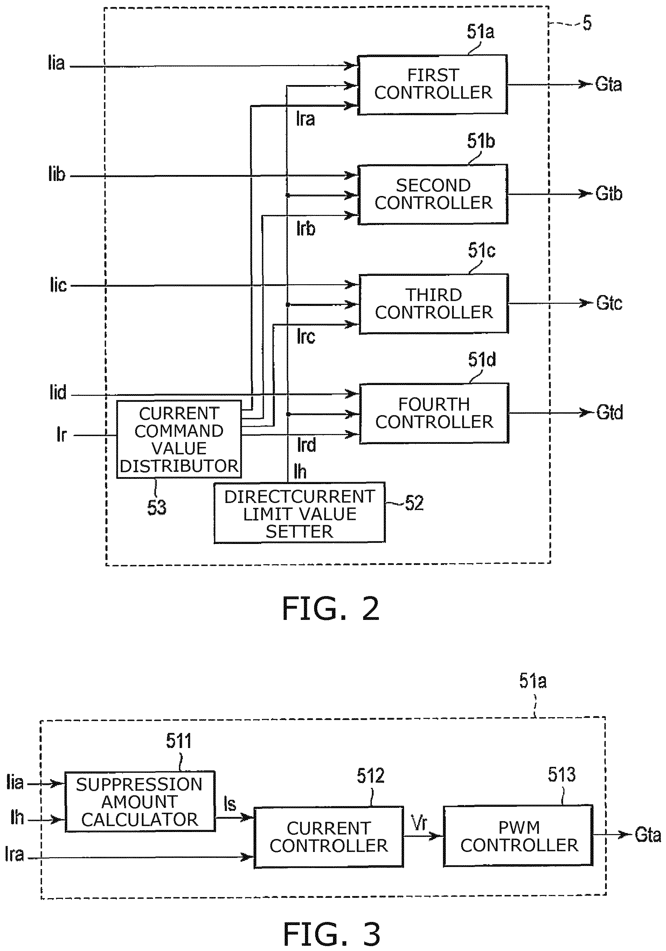

   FIG. 2 is a configuration diagram showing a configuration of a control device according to the first embodiment.
[Fig. 3]
   FIG. 3 is a configuration diagram showing a configuration of a first controller according to the first embodiment.
[Fig. 4]

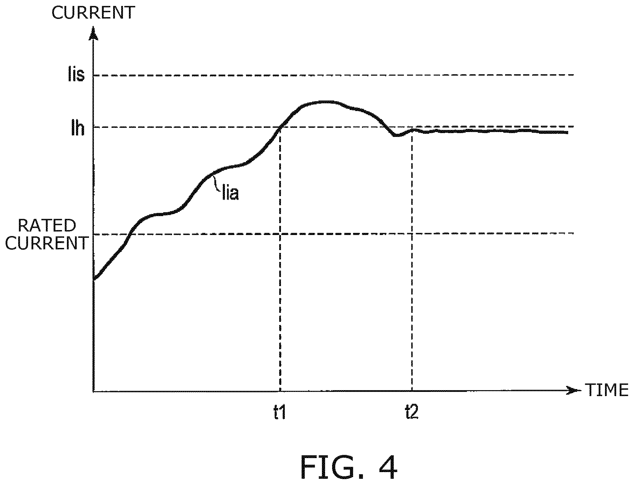

   FIG. 4 is a graph showing a change of a direct current of a first inverter according to the first embodiment.
[Fig. 5]

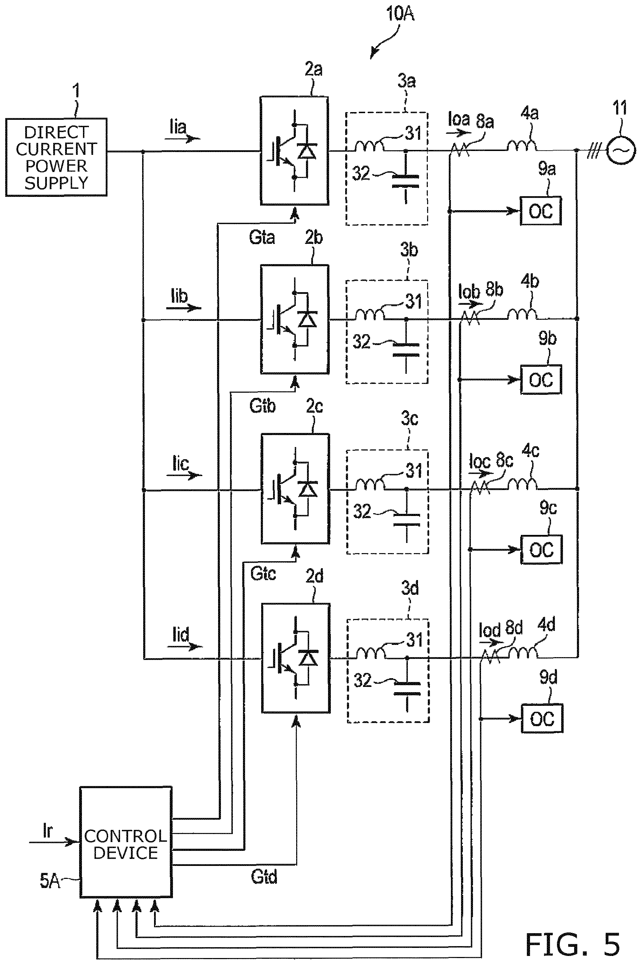

   FIG. 5 is a configuration diagram showing a configuration of a distributed power source system according to a second embodiment of the invention.
[Fig. 6]

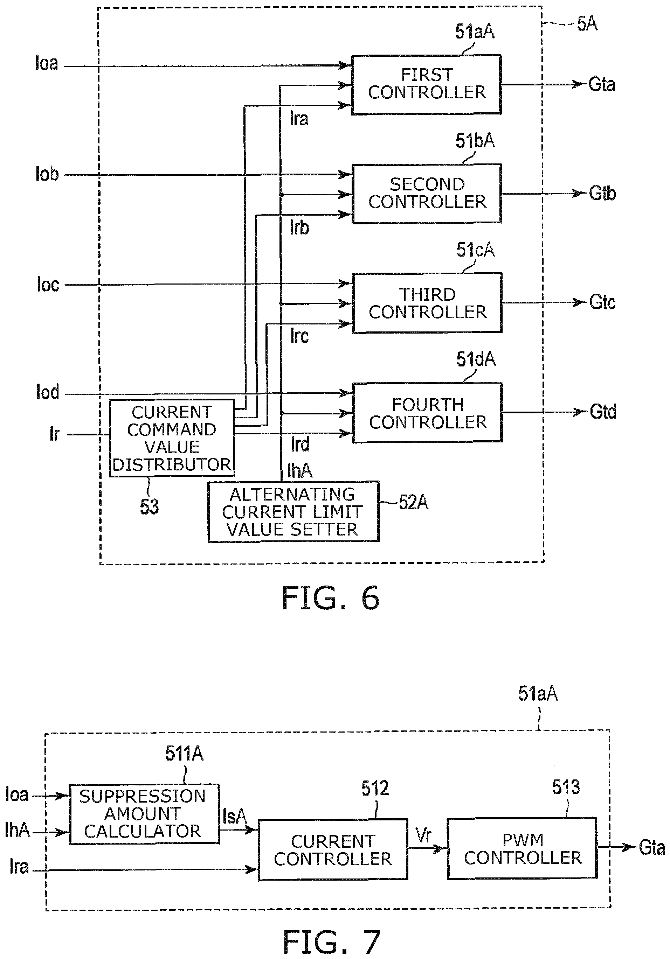

   FIG. 6 is a configuration diagram showing a configuration of a control device according to the second embodiment.
[Fig. 7]
   FIG. 7 is a configuration diagram showing a configuration of a first controller according to the second embodiment.
[Fig. 8]

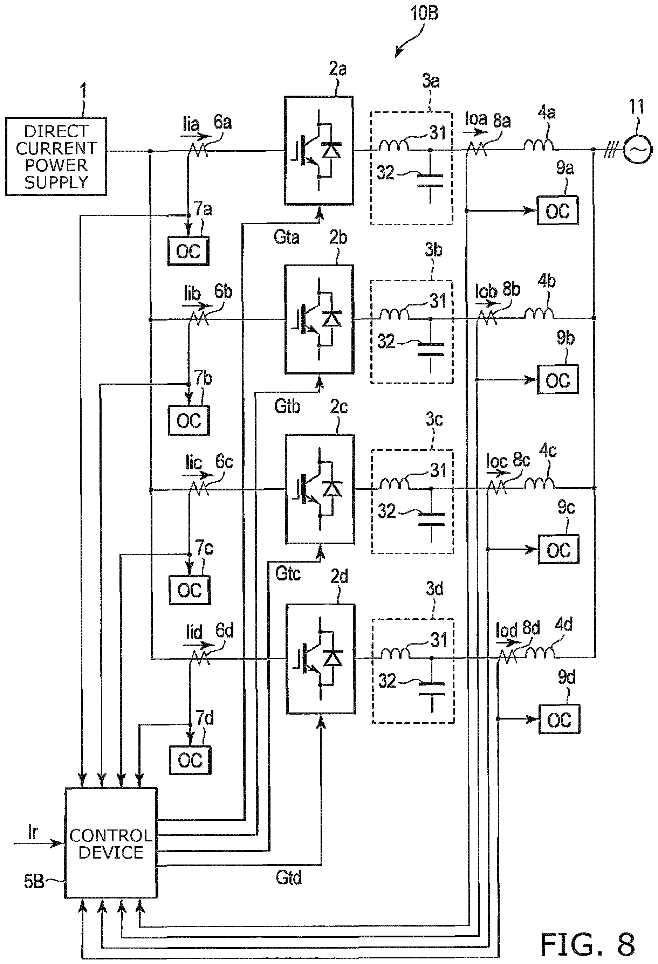

   FIG. 8 is a configuration diagram showing a configuration of a distributed power source system according to a third embodiment of the invention.
[Fig. 9]

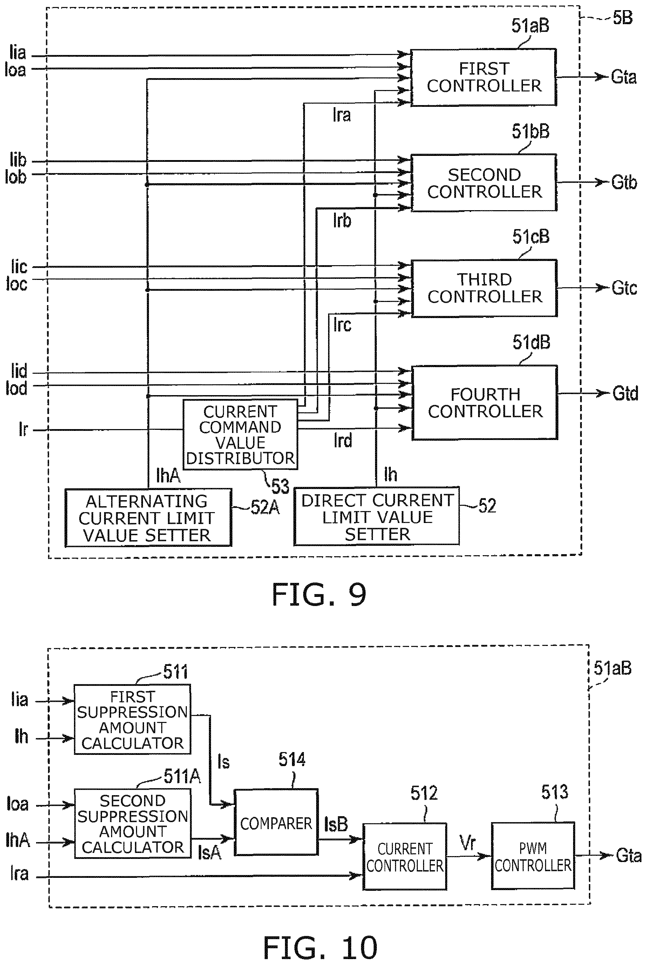

   FIG. 9 is a configuration diagram showing a configuration of a control device according to the third embodiment.
[Fig. 10]
   FIG. 10 is a configuration diagram showing a configuration of a first controller according to the third embodiment.

### [Description of Embodiments]

Embodiments of the invention will now be described with reference to the drawings.

### (First embodiment)

FIG. 1 is a configuration diagram showing a configuration of a distributed power source system 10 according to a first embodiment of the invention. The same portions in the drawings are marked with the same reference numerals; a detailed description thereof is omitted; and mainly the different portions are described.

The distributed power source system 10 includes a direct current power supply 1, four inverters 2a, 2b, 2c, and 2d, four alternating current filters 3a, 3b, 3c, and 3d, four connection reactors 4a, 4b, 4c, and 4d, a control device 5, four direct current sensors 6a, 6b, 6c, and 6d, and four direct-current overcurrent relays 7a, 7b, 7c, and 7d. The distributed power source system 10 supplies alternating current power to an electric power system 11 which is a load. For example, the distributed power source system 10 is a solar power generation system.

The direct current power supply 1 is a distributed power source that supplies direct current power to the four inverters 2a to 2d. For example, the direct current power supply 1 is a solar cell. The direct current power supply 1 may be anything that outputs direct current power. Also, the direct current power supply 1 may include multiple power supplies.

The direct current sides and the alternating current sides each are connected in parallel for the four inverters 2a to 2d. The direct current sides (the input sides) of the inverters 2a to 2d are connected to the direct current power supply 1. The alternating current sides (the output sides) of the inverters 2a to 2d are connected to the electric power system 11 via the alternating current filters 3a to 3d and the connection reactors 4a to 4d. The inverters 2a to 2d are power converters in which power conversion circuits (inverter circuits), that convert direct current power supplied from the direct current power supply 1 into three-phase alternating current power, are mounted. The inverters 2a to 2d supply the converted three-phase alternating current power to the electric power system 11. For example, in the case where the distributed power source system 10 is a solar power generation system, the inverters 2a to 2d are a PCS (power conditioning system).

The alternating current filters 3a to 3d are connected respectively to the alternating current sides of the inverters 2a to 2d. The alternating current filters 3a to 3d include reactors 31 and condensers 32. The alternating current filters 3a to 3d suppress harmonics output from the inverters 2a to 2d. The alternating current filters 3a to 3d may not be used.

The connection reactors 4a to 4d are connected to the alternating current sides of the alternating current filters 3a to 3d. The alternating current sides of the connection reactors 4a to 4d are connected to the electric power system 11. The connection reactors 4a to 4d may not be used; and connection transformers may be provided instead of the connection reactors 4a to 4d.

The direct current sensors 6a to 6d are provided respectively on the direct current sides of the inverters 2a to 2d. The direct current sensors 6a to 6d sense direct currents (input currents) Iia, Iib, Iic, and lid that are input respectively to the inverters 2a to 2d. The direct current sensors 6a to 6d output the sensed direct currents Iia to lid to the direct-current overcurrent relays 7a to 7d and the control device 5.

Based on the direct currents Iia to lid sensed by the direct current sensors 6a to 6d, the direct-current overcurrent relays 7a to 7d sense the overcurrents of the direct currents Iia to lid that are input respectively to the inverters 2a to 2d. The direct-current overcurrent relays 7a to 7d respectively sense the overcurrents when the direct currents Iia to lid exceed a preset setting value (a threshold of the direct current). The direct-current overcurrent relays 7a to 7d perform a protection operation of the corresponding inverters 2a to 2d when sensing each of the overcurrents. As the protection operation, the direct-current overcurrent relays 7a to 7d may stop the inverters 2a to 2d for which the overcurrent is sensed, or may open a circuit breaker provided in the major circuit for which the overcurrent is sensed. The direct-current overcurrent relays 7a to 7d may be realized as functions of the control device 5, may be mounted in each of the inverters 2a to 2d, or may be provided independently.

The control device 5 collectively controls the inverters 2a to 2d based on the direct currents Iia to lid sensed by the direct current sensors 6a to 6d and a total current command value Ir which is the command value for the total alternating current of alternating currents (output currents) Ioa, Iob, Ioc, and Iod output from all of the inverters 2a to 2d (in other words, the current output to the electric power system 11). The total current command value Ir may be input from a higher-level control system, may be calculated in the interior of the control device 5, or may be preset.

FIG. 2 is a configuration diagram showing the configuration of the control device 5 according to the embodiment.

The control device 5 includes four controllers 51a, 51b, 51c, and 51d, a direct current limit value setter 52, and a current command value distributor 53.

The total current command value Ir is input to the current command value distributor 53. The current command value distributor 53 generates individual current command values Ira, Irb, Irc, and Ird for the alternating currents Ioa to Iod of each of the inverters 2a to 2d based on the total current command value Ir. The current command value distributor 53 outputs the generated current command values Ira to Ird respectively to the controllers 51a to 51d. The current command value distributor 53 may determine the current command values Ira to Ird arbitrarily as long as the individual current command values Ira to Ird increase and decrease as the total current command value Ir increases and decreases. For example, the current command value distributor 53 may calculate and determine each of the current command values Ira to Ird according to predetermined proportions borne by the inverters 2a to 2d, or may set all of the current command values Ira to Ird to the same value by dividing uniformly by the number of the inverters 2a to 2d.

A direct current limit value Ih is preset in the direct current limit value setter 52. The direct current limit value Ih is a value that is slightly lower than the setting value set in the direct-current overcurrent relays 7a to 7d, and is a value that is higher than the rated direct current of the inverters 2a to 2d. The direct current limit value Ih is set to, for example, 1.19 [p.u.] (per unit) in the case where the rated direct current of the inverters 2a to 2d is set to 1 [p.u.] and a setting value Iis of the direct-current overcurrent relays 7a to 7d is set to 1.20 [p.u.]. The direct current limit value setter 52 outputs the set direct current limit value Ih to each of the controllers 51a to 51d.

The four controllers 51a to 51d are provided to correspond respectively to the four inverters 2a to 2d. The first controller 51a controls the first inverter 2a. The second controller 51b controls the second inverter 2b. The third controller 51c controls the third inverter 2c. The fourth controller 51d controls the fourth inverter 2d. The controllers 51a to 51d respectively perform pulse width modulation (PWM, pulse width modulation) control of the inverters 2a to 2d by outputting gate signals Gta, Gtb, Gtc, and Gtd.

The direct currents Iia to lid that are sensed by the direct current sensors 6a to 6d and input to the inverters 2a to 2d to be controlled, the current command values Ira to Ird that are generated by the current command value distributor 53 for the inverters 2a to 2d to be controlled, and the direct current limit value Ih that is set in the direct current limit value setter 52 are input to each of the controllers 51a to 51d. Normally, the controllers 51a to 51d respectively control the alternating currents Ioa to Iod of the inverters 2a to 2d to track the individually-input current command values Ira to Ird. As the direct currents Iia to lid approach the magnitude (the setting value) causing the direct-current overcurrent relays 7a to 7d to operate, the controllers 51a to 51d suppresses the current command values Ira to Ird so that the direct currents Iia to lid are limited to the direct current limit value Ih.

FIG. 3 is a configuration diagram showing the configuration of the first controller 51a according to the embodiment. The second to fourth controllers 51b to 51d are configured similarly to the first controller 51a; and a description is therefore omitted.

The first controller 51a includes a suppression amount calculator 511, a current controller 512, and a PWM controller 513.

The direct current limit value Ih and the direct current Iia of the first inverter 2a are input to the suppression amount calculator 511. Based on the direct current Iia and the direct current limit value Ih, the suppression amount calculator 511 calculates a suppression amount Is that suppresses the alternating current Ioa of the first inverter 2a. In the case where the direct current Iia does not exceed the direct current limit value Ih, the suppression amount calculator 511 sets the suppression amount Is to zero. At this time, the controller 51a does not suppress the alternating current Ioa of the first inverter 2a. In the case where the direct current Iia exceeds the direct current limit value Ih, the suppression amount calculator 511 calculates the suppression amount Is to increase based on a predetermined algorithm according to the difference between the direct current Iia and the direct current limit value Ih. The suppression amount calculator 511 outputs the calculated suppression amount Is to the current controller 512.

The current command value Ira and the suppression amount Is that are calculated by the suppression amount calculator 511 are input to the current controller 512. The current controller 512 controls the alternating current Ioa of the first inverter 2a based on the current command value Ira and the suppression amount Is. In the case where the suppression amount Is is zero, the current controller 512 calculates a voltage command value Vr so that the alternating current Ioa of the first inverter 2a tracks the current command value Ira. The voltage command value Vr is a value for controlling the output voltage of the inverter 2a. In the case where the suppression amount Is is nonzero, the current controller 512 calculates the voltage command value Vr so that the direct current Iia input to the first inverter 2a is suppressed according to the suppression amount Is. The current controller 512 outputs the calculated voltage command value Vr to the PWM controller 513.

Based on the voltage command value Vr calculated by the current controller 512, the PWM controller 513 generates the gate signal Gta that controls the output voltage of the first inverter 2a. The PWM controller 513 controls the output power Ioa of the first inverter 2a by outputting the generated gate signal Gta to a switching element included in the power conversion circuit of the first inverter 2a.

The method for controlling the direct current Iia of the first inverter 2a by the controller 51a according to the embodiment will now be described with reference to FIG. 4. FIG. 4 is a graph showing the change of the direct current Iia of the first inverter 2a. The setting value Iis shown in FIG. 4 is the setting value at which the direct-current overcurrent relay 7a operates.

Prior to a time t1, the direct current Iia of the inverter 2a is smaller than the direct current limit value Ih. At this time, the controller 51a performs a control to track the current command value Ira without suppressing the alternating current Ioa of the inverter 2a.

At the time t1, the direct current Iia of the inverter 2a becomes larger than the direct current limit value Ih. Subsequently as well, if the current command value Ira does not decrease, the controller 51a starts a control to suppress the increase of the direct current Iia and to reduce the direct current Iia to the direct current limit value Ih vicinity. The controller 51a suppresses the alternating current Ioa of the inverter 2a by reducing the current command value Ira according to the difference between the direct current Iia and the direct current limit value Ih.

At a time t2, the direct current Iia stabilizes at the direct current limit value Ih vicinity due to the suppression of the alternating current Ioa of the inverter 2a. Therefore, the direct current Iia does not reach the setting value Iis even if the current command value Ira does not decrease. Thereby, the operation of the direct-current overcurrent relay 7a is suppressed.

The operation of the distributed power source system 10 by the control of the control device 5 will now be described.

First, the preconditions will be described.

It is taken that the specifications of the four inverters 2a to 2d all are the same, but there are individual differences. When respectively converting the direct currents Iia to lid and the alternating currents Ioa to Iod into pu values using the rated currents as references, it is taken that all of the inverters 2a to 2d are constantly the same. In other words, when direct currents Iia to lid of 1.0 [p.u.] are input to the inverters 2a to 2d, alternating currents Ioa to Iod of 1.0 [p.u.] are output. It is taken that the setting value of the direct-current overcurrent relays 7a to 7d is set to 1.2 [p.u.] which is 1.2 times the rated direct current. It is taken that the direct current limit value Ih is set to 1.19 [p.u.].

Here, an output from the distributed power source system 10 of a current of 4 [p.u.] which is 4 times the rated alternating current of one of the inverters 2a to 2d is considered. In such a case, the total current command value Ir is set to cause 4 [p.u.] to be output from the distributed power source system 10. If a current of 1 [p.u.] is output from each of the four inverters 2a to 2d, a total current of 4 [p.u.] is output from the distributed power source system 10. Therefore, the control device 5 collectively controls the four inverters 2a to 2d by setting the current command values Ira to Ird to cause 1 [p.u.] to be output from each of the inverters 2a to 2d.

In such a case, even if the current command values Ira to Ird of the inverters 2a to 2d are the same value, the same direct currents Iia to lid are not always input to the inverters 2a to 2d due to the individual differences.

Here, it is taken that a current Iia of 1.19 [p.u.] is input to the first inverter 2a; and currents Iib to lid of 0.8 [p.u.] are input respectively to the second to fourth inverters 2b to 2d. At this time, the alternating current Ioa of the first inverter 2a is 1.19 [p.u.]; and the alternating currents Iob to Iod of the second to fourth inverters 2b to 2d each are 0.8 [p.u.]. Accordingly, the total of the alternating currents Ioa to Iod of the four inverters 2a to 2d is 3.59 [p.u.].

Because the total of the alternating currents Ioa to Iod of the four inverters 2a to 2d does not satisfy 4 [p.u.], it is necessary to further increase the total current command value Ir. When the total current command value Ir is increased, the current command values Ira to Ird of the inverters 2a to 2d each increase accordingly. Here, the direct current Iia of the first inverter 2a is 1.19 [p.u.] and has reached the direct current limit value Ih. Accordingly, even if the total current command value Ir is increased, the direct current Iia substantially does not increase because the suppression of the current command value Ira of the first inverter 2a is performed. Thereby, even if the total current command value Ir is increased, the direct-current overcurrent relay 7a does not operate.

On the other hand, the direct currents Iib to lid of the second to fourth inverters 2b to 2d are 0.8 [p.u.]; and there is ample margin to increase each of the alternating currents Iob to Iod. Accordingly, when the total current command value Ir is increased, the current command values Irb to Ird of the second to fourth inverters 2b to 2d increase according to the increased amount.

As a result, even if the total current command value Ir is increased until the desired current is output from the distributed power source system 10, the direct-current overcurrent relays 7a to 7d do not operate due to the direct currents Iia to lid of a portion of the inverters 2a to 2d. Thereby, the stopping of the distributed power source system 10 due to the operation of a portion of the direct-current overcurrent relays 7a to 7d can be avoided.

According to the embodiment, the overcurrent of the direct currents Iia to lid of a portion of the inverters 2a to 2d can be suppressed by determining, for each of the inverters 2a to 2d, the suppression amounts Is that suppress the individual current command values Ira to Ird based on the direct currents Iia to Iid. Thereby, the stopping of the distributed power source system 10 by the protection operation due to the overcurrent of a portion of the direct currents Iia to lid can be suppressed.

Because the overcurrent of a portion of the direct currents Iia to lid is suppressed, in the case where the increase of the total current command value Ir is continued, the direct currents Iia to lid of the inverters 2a to 2d increase uniformly to the upper limit without causing the direct-current overcurrent relays 7a to 7d to operate. Thereby, the output power of all of the inverters 2a to 2d can be pulled upward to the maximum value without causing the direct-current overcurrent relays 7a to 7d to operate.

### (Second embodiment)

FIG. 5 is a configuration diagram showing the configuration of a distributed power source system 10A according to a second embodiment of the invention.

The distributed power source system 10A is the distributed power source system 10 according to the first embodiment shown in FIG. 1, in which the control device 5 is replaced with a control device 5A, the four direct current sensors 6a, 6b, 6c, and 6d are replaced respectively with four alternating current sensors 8a, 8b, 8c, and 8d, and the four direct-current overcurrent relays 7a, 7b, 7c, and 7d are replaced respectively with four alternating-current overcurrent relays 9a, 9b, 9c, and 9d. The other aspects are similar to those of the first embodiment.

The alternating current sensors 8a to 8d are provided respectively on the alternating current sides of the inverters 2a to 2d. The alternating current sensors 8a to 8d sense the alternating currents (the output currents) Ioa, Iob, Ioc, and Iod output respectively from the inverters 2a to 2d. The alternating current sensors 8a to 8d output the sensed alternating currents Ioa to Iod to the control device 5A and the alternating-current overcurrent relays 9a to 9d.

Based on the alternating currents Ioa to Iod sensed by the alternating current sensors 8a to 8d, the alternating-current overcurrent relays 9a to 9d sense the overcurrents of the alternating currents Ioa to Iod output respectively from the inverters 2a to 2d. The alternating-current overcurrent relays 9a to 9d respectively sense the overcurrents when the alternating currents Ioa to Iod exceed a preset setting value (a threshold of the alternating current). When the alternating-current overcurrent relays 9a to 9d respectively sense the overcurrents, the protection operations of the corresponding inverters 2a to 2d are performed. The other aspects are similar to those of the direct-current overcurrent relays 7a to 7d according to the first embodiment.

The control device 5A collectively controls the inverters 2a to 2d based on the total current command value Ir and the alternating currents Ioa to Iod sensed by the alternating current sensors 8a to 8d. Because the control device 5A is configured similarly to the control device 5 according to the first embodiment, mainly the different portions are described.

FIG. 6 is a configuration diagram showing the configuration of the control device 5A according to the embodiment.

The control device 5A includes the current command value distributor 53 according to the first embodiment, four controllers 51aA, 51bA, 51cA, and 51dA, and an alternating current limit value setter 52A.

An alternating current limit value IhA is preset in the alternating current limit value setter 52A. The alternating current limit value IhA is a value that is slightly lower than the setting value set in the alternating-current overcurrent relays 9a to 9d, and is a value that is higher than the rated alternating current of the inverters 2a to 2d. The alternating current limit value IhA is set to, for example, 1.19 [p.u.] in the case where the rated alternating current of the inverters 2a to 2d is set to 1 [p.u.] and the setting value of the alternating-current overcurrent relays 9a to 9d is set to 1.20 [p.u.]. The alternating current limit value setter 52A outputs the set alternating current limit value IhA to each of the controllers 51aA to 51dA.

The alternating currents Ioa to Iod that are sensed by the alternating current sensors 8a to 8d and output from the inverters 2a to 2d to be controlled, the current command values Ira to Ird that are generated by the current command value distributor 53 for the inverters 2a to 2d to be controlled, and the alternating current limit value IhA that is set in the alternating current limit value setter 52A are input respectively to the controllers 51aA to 51dA. Normally, the controllers 51aA to 51dA respectively control the alternating currents Ioa to Iod of the inverters 2a to 2d to track the individually-input current command values Ira to Ird. As the alternating currents Ioa to Iod approach the magnitude (the setting value) causing the alternating-current overcurrent relays 9a to 9d to operate, the controllers 51aA to 51dA suppress the current command values Ira to Ird so that the alternating currents Ioa to Iod are limited to the alternating current limit value IhA. For the other aspects, the controllers 51aA to 51dA are similar respectively to the controllers 51a to 51d according to the first embodiment.

FIG. 7 is a configuration diagram showing the configuration of the first controller 51aA according to the embodiment. The second to fourth controllers 51bA to 51dA are configured similarly to the first controller 51aA; and a description is therefore omitted.

The first controller 51aA is the controller 51a according to the first embodiment shown in FIG. 3, in which the suppression amount calculator 511 is replaced with a suppression amount calculator 511A. The other aspects are similar to those of the first controller 51a according to the first embodiment.

The alternating current Ioa of the first inverter 2a and the alternating current limit value IhA are input to the suppression amount calculator 511A. Based on the alternating current Ioa and the alternating current limit value IhA, the suppression amount calculator 511A calculates a suppression amount IsA that suppresses the alternating current Ioa of the first inverter 2a. In the case where the alternating current Ioa does not exceed the alternating current limit value IhA, the suppression amount calculator 511A sets the suppression amount IsA to zero. At this time, the controller 51aA does not suppress the alternating current Ioa of the first inverter 2a. In the case where the alternating current Ioa exceeds the alternating current limit value IhA, the suppression amount calculator 511A calculates the suppression amount IsA to increase based on a predetermined algorithm according to the difference between the alternating current Ioa and the alternating current limit value IhA. The suppression amount calculator 511A outputs the calculated suppression amount IsA to the current controller 512. For the other aspects, the suppression amount calculator 511A is similar to the suppression amount calculator 511 according to the first embodiment.

Similarly to the first embodiment, the current controller 512 and the PWM controller 513 generate the gate signal Gta based on the current command value Ira and the suppression amount IsA.

Thus, the controllers 51aA to 51dA respectively control the alternating currents Ioa to Iod similarly to the first embodiment so that the alternating currents Ioa to Iod of the inverters 2a to 2d do not exceed the setting value of the alternating-current overcurrent relays 9a to 9d.

According to the embodiment, operations and effects similar to those of the first embodiment can be obtained by determining, based on the alternating currents Ioa to Iod, the suppression amount IsA that suppresses the individual current command values Ira to Ird for each of the inverters 2a to 2d.

### (Third embodiment)

FIG. 8 is a configuration diagram showing the configuration of a distributed power source system 10B according to a third embodiment of the invention.

The distributed power source system 10B is the distributed power source system 10 according to the first embodiment shown in FIG. 1, in which the control device 5 is replaced with a control device 5B, and the four alternating-current overcurrent relays 9a to 9d and the four alternating current sensors 8a to 8d according to the second embodiment shown in FIG. 5 are added. The other aspects are similar to those of the first embodiment.

The control device 5B collectively controls the inverters 2a to 2d based on the total current command value Ir, the direct currents Iia to lid sensed by the direct current sensors 6a to 6d, and the alternating currents Ioa to Iod sensed by the alternating current sensors 8a to 8d. Because the control device 5B is configured similarly to the control device 5 according to the first embodiment, mainly the different portions are described.

FIG. 9 is a configuration diagram showing the configuration of the control device 5B according to the embodiment.

The control device 5B includes four controllers 51aB, 51bB, 51cB, and 51dB, the direct current limit value setter 52 according to the first embodiment, the alternating current limit value setter 52A according to the second embodiment, and the current command value distributor 53 according to the first embodiment.

The direct currents Iia to lid that are sensed by the direct current sensors 6a to 6d and input to the inverters 2a to 2d to be controlled, the alternating currents Ioa to Iod that are sensed by the alternating current sensors 8a to 8d and output from the inverters 2a to 2d to be controlled, the current command values Ira to Ird that are generated by the current command value distributor 53 for the inverters 2a to 2d to be controlled, the direct current limit value Ih that is set in the direct current limit value setter 52, and the alternating current limit value IhA that is set in the alternating current limit value setter 52A are input respectively to the controllers 51aB to 51dB. Normally, the controllers 51aB to 51dB respectively control the alternating currents Ioa to Iod of the inverters 2a to 2d to track the individually-input current command values Ira to Ird. As the direct currents Iia to lid approach the magnitude (the setting value) causing the direct-current overcurrent relays 7a to 7d to operate, or the alternating currents Ioa to Iod approach the magnitude (the setting value) causing the alternating-current overcurrent relays 9a to 9d to operate, similarly to the first embodiment or the second embodiment, the controllers 51aB to 51dB suppress the current command values Ira to Ird. For the other aspects, the controllers 51aB to 51dB are similar respectively to the controllers 51a to 51d according to the first embodiment.

FIG. 10 is a configuration diagram showing the configuration of the first controller 51aB according to the embodiment. Because the second to fourth controllers 51bB to 51dB are configured similarly to the first controller 51aB, a description is omitted.

The first controller 51aB is the controller 51a according to the first embodiment shown in FIG. 3, in which a comparer 514 and the suppression amount calculator 511A according to the second embodiment shown in FIG. 7 are added. For the other aspects, the first controller 51aB is similar to the controller 51a according to the first embodiment.

The first suppression amount Is that is calculated by the first suppression amount calculator 511 and the second suppression amount IsA that is calculated by the second suppression amount calculator 511A are input to the comparer 514. The comparer 514 compares the first suppression amount Is and the second suppression amount IsA and outputs the larger to the current controller 512 as a third suppression amount IsB.

Here, for direct current and alternating current, the comparison cannot be simply of the magnitude. To be able to compare direct current and alternating current, the direct current Iia, the direct current limit value Ih, the alternating current Ioa, the alternating current limit value IhA, the current command value Ira, the first current suppression amount Is, and the second current suppression amount IsA each are normalized by respectively using the proportions when the rated current of the inverter is set to 1 [p.u]. Also, it is taken that a calculation method that determines the normalized value for any current is preset in the comparer 514. The normalized value of the alternating current may be determined based on any value of the effective value, the instantaneous value, the average value, the peak value, etc.

Similarly to the first embodiment, the first suppression amount Is is a value calculated based on the direct current limit value Ih and the direct current Iia of the first inverter 2a to suppress the operation of the direct-current overcurrent relay 7a. Similarly to the second embodiment, the second suppression amount IsA is a value calculated based on the alternating current limit value IhA and the alternating current Ioa of the first inverter 2a to suppress the operations of the alternating-current overcurrent relays 9a to 9d.

Similarly to the first embodiment, the current controller 512 and the PWM controller 513 generate the gate signal Gta based on the current command value Ira and the third suppression amount IsB.

According to the embodiment, operations and effects in which the operations and effects due to the second embodiment are added to the operations and effects due to the first embodiment can be obtained by determining, based on the direct currents Iia to lid and the alternating currents Ioa to Iod, the suppression amounts IsB suppressing the individual current command values Ira to Ird for each of the inverters 2a to 2d.

Although the embodiments are described using the inverters 2a to 2d that convert direct current power into three-phase alternating current power, anything that performs power conversion may be used. For example, an inverter that converts direct current power into single-phase alternating current power or other alternating current power may be used; a converter that converts alternating current power into direct current power may be used; a converter that converts direct current power into direct current power may be used; or a converter that converts alternating current power into alternating current power may be used. Also, the system is not limited to a distributed power source system; and any system may be used. Also, as long as the electrical power is supplied from the system, the load is not limited to an electric power system; and any load may be used. Further, the direct current power supply 1 can be modified appropriately to be an alternating current power supply, a device outputting alternating current power, etc., to match the configurations of these systems.

Although the configuration of the four inverters 2a to 2d is described in the embodiments, the number of inverters may be any number of 2 or more. The specifications such as the capacities, etc., of the inverters 2a to 2d all may be the same, or all may be different.

Although the direct current limit value Ih or the alternating current limit value IhA is used commonly in all of the inverters 2a to 2d in the embodiments, the direct current limit value Ih or the alternating current limit value IhA may be provided individually to each of the inverters 2a to 2d.

Although the suppression amounts Is are calculated based on the sensed direct currents Iia to lid to suppress the operations of the direct-current overcurrent relays 7a to 7b in the first and third embodiments, the suppression amount may be calculated based on the alternating currents Ioa to Iod to suppress the operations of the direct-current overcurrent relays 7a to 7b. Similarly, although the suppression amount IsA is calculated based on the sensed alternating currents Ioa to Iod to suppress the operations of the alternating-current overcurrent relays 9a to 9d in the second and third embodiments, the suppression amount may be calculated based on the direct currents Iia to lid to suppress the operations of the alternating-current overcurrent relays 9a to 9d. These configurations can be configured similarly to the embodiments by presetting the direct current limit value setter or the alternating current limit value by considering specification data, operation data, etc., such as the power conversion rate or the like of each of the inverters 2a to 2d.

Although the direct-current overcurrent relays 7a to 7b or the alternating-current overcurrent relays 9a to 9d are used as the method of protecting the inverters 2a to 2d in the embodiments, this is not limited thereto. The relay is not limited to an overcurrent relay and may be any type of relay; and this is not limited to a relay and may be a breaker, a fuse, etc.

The invention is not limited as-is to the embodiments recited above and can be embodied in practice by modifying the components without departing from the spirit of the embodiments. Also, various inventions can be configured by appropriate combinations of the multiple components disclosed in the embodiments recited above. For example, several components may be deleted from all of the components shown in the embodiments. Further, the components may be appropriately combined between different embodiments.

## Claims

1. A control device of a power converter, comprising:
an individual current command value generator generating a plurality of individual current command values based on a total current command value, the total current command value being a command value for a total output current of a plurality of power conversion circuits, the plurality of individual current command values being command values respectively for output currents of the plurality of power conversion circuits;
a plurality of controllers respectively controlling the plurality of power conversion circuits based on the plurality of individual current command values generated by the individual current command value generator;
a plurality of current sensors each sensing at least one current of an input current or an output current respectively for the plurality of power conversion circuits; and
a plurality of output current suppressors provided respectively for the plurality of power conversion circuits, the output current suppressors suppressing the individual current command value when the current sensed by the current sensor exceeds a current limit value, the current limit value being preset, the current limit value being lower than a current causing a protection operation to protect the power conversion circuit.

2. The control device of the power converter according to claim 1, wherein the plurality of output current suppressors comprises determining suppression amounts to suppress the individual current command values based on differences between the current limit value and the currents sensed respectively by the current sensors.

3. The control device of the power converter according to claim 1, wherein
the plurality of power conversion circuits converts direct current power into alternating current power, and
the plurality of current sensors senses direct currents input respectively to the plurality of power conversion circuits.

4. The control device of the power converter according to claim 3, comprising a plurality of direct-current overcurrent relays provided respectively on direct current sides of the plurality of power conversion circuits,
the protection operation being operation of the plurality of direct-current overcurrent relays.

5. The control device of the power converter according to claim 1, wherein
the plurality of power conversion circuits converts direct current power into alternating current power, and
the plurality of current sensors senses alternating currents output respectively from the plurality of power conversion circuits.

6. The control device of the power converter according to claim 5, comprising a plurality of alternating-current overcurrent relays provided respectively on alternating current sides of the plurality of power conversion circuits,
the protection operation being operation of the plurality of alternating-current overcurrent relays.

7. A power converter, comprising:
a plurality of power conversion circuits;
an individual current command value generator generating a plurality of individual current command values based on a total current command value, the total current command value being a command value for a total output current of the plurality of power conversion circuits, the plurality of individual current command values being command values respectively for output currents of the plurality of power conversion circuits;
a plurality of controllers respectively controlling the plurality of power conversion circuits based on the plurality of individual current command values generated by the individual current command value generator;
a plurality of current sensors each sensing at least one current of an input current or an output current respectively for the plurality of power conversion circuits; and
a plurality of output current suppressors provided respectively for the plurality of power conversion circuits, the output current suppressors suppressing the individual current command value when the current sensed by the current sensor exceeds a current limit value, the current limit value being preset, the current limit value being lower than a current causing a protection operation to protect the power conversion circuit.

8. A method for controlling a power converter, comprising:
generating a plurality of individual current command values based on a total current command value, the total current command value being a command value for a total output current of a plurality of power conversion circuits, the plurality of individual current command values being command values respectively for output currents of the plurality of power conversion circuits;
respectively controlling the plurality of power conversion circuits based on the generated plurality of individual current command values;
sensing at least one current of an input current or an output current for each of the plurality of power conversion circuits; and
suppressing the individual current command value for each of the plurality of power conversion circuits, the suppressing being performed when the sensed current exceeds a current limit value, the current limit value being preset, the current limit value being lower than a current causing a protection operation to protect the power conversion circuit.
